# EUROPÄISCHE PATENTANMELDUNG

(11) **EP 4 471 934 A2**
(43) Veröffentlichungstag der Anmeldung: **04.12.2024**
(21) Anmeldenummer: 24166713.8
(22) Anmeldetag: 27.03.2024
(51) Int. Cl.: H01M 10/48, G01R 31/36, G01R 31/364, G01R 31/55, G01R 31/66, H01M 50/516, H01M 50/519

(54) **BATTERIEANORDNUNG, BATTERIESYSTEM MIT DER BATTERIEANORDNUNG SOWIE VERFAHREN ZUM PRÜFEN DES FERTIGUNGSZUSTANDS ODER DER BATTERIEANORDNUNG**

(30) Priorität: 31.05.2023 DE 102023114308
(71) Anmelder: Manz AG, 72768 Reutlingen (DE)
(72) Erfinder: Freundt, Martin, 73732 Esslingen (DE)
(74) Vertreter: Kanzlei Dr. Negendanck Patentmanufaktur

(57) **Zusammenfassung**

Es wird eine Batterieanordnung 1 vorgeschlagen mit mindestens einer Batterie 2, wobei die Batterie 2 mindestens einen Pol 3a zur elektrischen Kontaktierung der Batterie 2 aufweist, wobei der Pol 3a einen ersten Kontaktierungspartner bildet, mit einem Kontaktelement 4 zur elektrischen Kontaktierung des Pols 3a, wobei das Kontaktelement 4 einen zweiten Kontaktierungspartner bildet, wobei in einem Fügezustand als einen ersten Fertigungszustand der Batterieanordnung 1 das Kontaktelement 4 in mindestens einem Fügebereich 5 fügebereit/fügegerecht auf dem Pol 3a aufliegt und/oder wobei in einem Kontaktierungszustand der Batterieanordnung 1 als einen zweiten Fertigungszustand das Kontaktelement 4 mit dem Pol 3a in einem und/oder dem mindestens einem Fügebereich 5 stoffschlüssig verbunden ist, mit einem Sensorabschnitt 6 zur Überprüfung von mindestens einem der Fertigungszustände der Batterieanordnung 1, wobei der Sensorabschnitt 6 zwischen dem Kontaktelement 4 und der Batterie 2 angeordnet ist, wobei der Sensorabschnitt 6 auf einem der Kontaktierungspartner zumindest abschnittsweise oder vollständig aufgedruckt ist.

## Beschreibung

Die Erfindung betrifft eine Batterieanordnung mit den Merkmalen des Anspruchs 1. Die Erfindung betrifft auch ein Batteriesystem mit einer Mehrzahl derartiger Batterieanordnungen sowie ein Verfahren zum Prüfen des Fertigungszustands der Batterieanordnung.

Speichereinheiten für Fahrzeuge, elektrische Geräte etc. weisen oftmals Batteriepacks mit einer Vielzahl von Einzelbatterien auf. Diese Einzelbatterien müssen in den Batteriepacks miteinander und mit einer Verbraucherstruktur elektrisch kontaktiert werden. Prinzipiell ist die elektrische Kontaktierung ein einfacher Fertigungsvorgang. Jedoch müssen in derartigen Batteriepacks eine Vielzahl von Einzelbatterien kontaktiert werden, so dass rein statistisch betrachtet es nicht auszuschließen ist, dass eine oder mehrere Kontaktierungen nicht vollständig erfolgen. In Abhängigkeit der Kontaktierungsstruktur kann bereits ein einziger Fehlkontakt zu einem Ausfall oder einer Leistungsminderung des Batteriepacks führen. Somit ist es zwingend notwendig, entweder die Kontaktierung 100%-fehlerfrei umzusetzen oder zumindest nachfolgend die Kontaktierung überprüfen zu können, um etwaige Fehlkontakte nachträglich beheben zu können oder eine instabile Kontaktierung die im späteren Betrieb versagen könnte vorab identifizieren zu können.

Es ist eine Aufgabe der vorliegenden Erfindung, eine Batterieanordnung mit einer verbesserten Überprüfungsmöglichkeit für die Kontaktierung vorzuschlagen.

Diese Aufgabe wird durch eine Batterieanordnung mit den Merkmalen des Anspruchs 1, durch ein Batteriesystem mit den Merkmalen des Anspruchs 15 sowie durch ein Verfahren zum Prüfen des Fertigungszustands der Batterieanordnung mit den Merkmalen des Anspruchs 16 gelöst. Bevorzugte oder vorteilhafte Ausführungsformen der Erfindung ergeben sich aus den Unteransprüchen, der nachfolgenden Beschreibung sowie der beigefügten Figuren.

Die Erfindung betrifft somit eine Batterieanordnung, welche insbesondere für ein Batteriesystem geeignet und/oder ausgebildet ist.

Die Batterieanordnung weist mindestens eine Batterie auf. Die Batterie ist insbesondere als eine Einzelzelle ausgebildet. Es kann jedoch auch vorgesehen sein, dass die Batterie als eine Mehrfachzelle realisiert ist. Die Batterie kann insbesondere als eine aufladbare Batterie, im Speziellen als ein Akkumulator, ausgebildet sein. Insbesondere speichert die Batterie die Energie auf einer elektrochemischen Basis. Alternativ ist die Batterie als eine Kondensatorbatterie ausgebildet.

Die Batterie weist mindestens einen Pol zur elektrischen Kontaktierung der Batterie auf. Insbesondere ist der Pol als ein Pluspol oder als ein Minuspol ausgebildet. Vorzugsweise umfasst die Batterie mindestens einen Pluspol und mindestens einen Minuspol. Der Pol bildet einen ersten Kontaktierungspartner in der Batterieanordnung.

Die Batterieanordnung weist ein Kontaktelement zur elektrischen Kontaktierung des Pols auf. Das Kontaktelement kann beispielsweise als ein Metallstreifen, eine Kontaktierungsstruktur etc. ausgebildet sein. Insbesondere ist das Kontaktelement zumindest im Kontaktierungsbereich biegesteif ausgebildet. Im Speziellen ist die Fügestelle des Kontaktelements biegesteif ausgebildet. Der Übergang zwischen der Fügestelle und einer Hauptstruktur des Kontaktelements zum Ableiten des von ggf. verschiedenen Batterien eingesammelten Stroms kann biegeweich ausgebildet sein, damit ein Toleranzausgleich stattfinden kann, um thermische Bewegungen, geometrische Toleranzen, Ausgleichsbewegung beim Zusammenfügen usw. auszugleichen und damit keine Spannungen oder reduzierte Spannungen in der Fügestelle entstehen und die Verbindung nicht durch Spannungen im Material geschädigt wird. Lokal (insbesondere in wenigen Millimetern gemessen), ist das Kontaktelement jedoch bevorzugt biegesteif ausgebildet, insbesondere, da die Aspektverhältnisse in dem Kontaktierungsbereich das sicherstellen. Über das Kontaktelement wird der Pol beispielsweise mit einer Verbraucherstruktur verbunden. Das Kontaktelement bildet einen zweiten Kontaktierungspartner in der Batterieanordnung.

Es ist vorgesehen, dass die Batterieanordnung in einem Fügezustand als einen ersten Fertigungszustand der Batterieanordnung das Kontaktelement in mindestens einem Fügebereich fügebereit und/oder fügegerecht auf dem Pol aufliegt.

Der Fügebereich ist im Fügezustand insbesondere als der Bereich definiert, in dem das Kontaktelement fügebereit und/oder fügegerecht auf dem Pol aufliegt. Alternativ oder ergänzend ist im Kontaktierungszustand als der Bereich definiert, in dem das Kontaktelement mit dem Pol stoffschlüssig und/oder dauerhaft kontaktiert verbunden ist.

In dem Fügezustand sind somit der Pol und das Kontaktelement noch nicht insbesondere stoffschlüssig und/oder dauerhaft kontaktiert, sondern fügegerecht und/oder fügebereit, jedoch insbesondere unverbunden oder nur "geheftet" angeordnet. Dabei kann das Kontaktelement kontaktierend auf dem Pol aufliegen. Alternativ hierzu ist zwischen dem Kontaktelement und dem Pol ein Fügespalt vorhanden, welcher jedoch so gering bemessen ist, dass der nachfolgende Fügeprozess erfolgreich durchgeführt werden kann. Sowohl bei der mechanischen Kontaktierung als auch beim Aufliegen mit Fügespalt befindet sich die Batterieanordnung in dem Fügezustand und ist somit fügebereit und/oder fügegerecht angeordnet.

Alternativ oder ergänzend befindet sich die Batterieanordnung in einem Kontaktierungszustand der Batterieanordnung, wobei der Kontaktierungszustand einen zweiten Fertigungszustand bildet. In dem Kontaktierungszustand ist das Kontaktelement mit dem Pol in einem und/oder in dem mindestens einen Fügebereich stoffschlüssig verbunden. Der Stoffschluss erfolgt insbesondere über ein Metallschmelzverfahren, insbesondere über ein Metallschweißverfahren, insbesondere Laserstrahlschweißen, Ultraschallschweißen oder Widerstandsschweißen. Insbesondere erfolgt das Fügen ohne Zusatzwerkstoff. Alternativ hierzu kann auch ein Metalllötverfahren eingesetzt werden, wobei z.B. das Lot über ein Lotdepot an den Kontaktierungspartnern bereitgestellt ist.

Die Batterieanordnung weist einen Sensorabschnitt auf, wobei der Sensorabschnitt geeignet und/oder ausgebildet ist, mindestens einen der Fertigungszustände der Batterieanordnung zu überprüfen. Es kann somit vorgesehen sein, dass der Sensorabschnitt den Fügezustand oder den Kontaktierungszustand oder alternativ den Fügezustand und den Kontaktierungszustand prüft. Insbesondere erfolgt die Überprüfung im Hinblick auf eine fügegerechte und/oder fügebereite Positionierung in dem Fügezustand und/oder in Bezug auf eine ausreichende Kontaktierung zwischen dem Kontaktelement und dem Pol in dem Kontaktierungszustand.

Im Rahmen der Erfindung wird vorgeschlagen, dass der Sensorabschnitt zwischen dem Kontaktelement und der Batterie, insbesondere im Bereich des Pols angeordnet ist. Bevorzugt ist der Sensorabschnitt zwischen dem Kontaktelement und der Batterie eingeklemmt. Betrachtet man beispielsweise die Batterieanordnung in einer Draufsicht, so sind der Sensorabschnitt, das Kontaktelement und die Batterie, insbesondere der Pol der Batterie, deckungsgleich positioniert. Insbesondere ist der Sensorabschnitt im Bereich des Pols angeordnet.

Es ist eine Überlegung der Erfindung, den Sensorabschnitt möglichst nahe zu der eigentlichen Prüfstelle, nämlich dem Fügebereich, zu bringen. Dadurch, dass der Sensorabschnitt zwischen dem Kontaktelement und der Batterie, insbesondere im Bereich des Pols und/oder des Fügebereichs angeordnet ist, kann der Sensorabschnitt den Fügebereich unmittelbar erfassen. Damit wird eine Batterieanordnung vorgeschlagen, welche eine neuartige Überprüfungsmöglichkeit für die Positionierung und/oder Kontaktierung des Kontaktelements an dem Pol aufweist.

Bei einer bevorzugten Ausgestaltung der Erfindung ist der Sensorabschnitt umlaufend und/oder überdeckend zu dem mindestens einen Fügebereich angeordnet. Alternativ oder ergänzend ist der Sensorabschnitt benachbart, insbesondere unmittelbar benachbart positioniert. Durch die unmittelbare Nähe zu dem Fügebereich, welche - wie bereits beschrieben durch die Positionierung des Sensorabschnitts erreicht wird, kann der Fügebereich besonders einfach hinsichtlich des Fertigungszustands geprüft werden.

Insbesondere kann der Sensorabschnitt auf dem Kontaktelement und/oder auf der Batterie aufgebracht sein. Es kann auch sein, dass der Sensorabschnitt teilweise auf dem Kontaktelement und teilweise auf der Batterie durch Beschichten aufgebracht ist.

Bei einer bevorzugten Ausgestaltung der Erfindung ist der Sensorabschnitt zumindest abschnittsweise oder vollständig auf einem oder beiden der Kontaktierungspartner durch Beschichten aufgebracht. Die Beschichtung zur Erzeugung des Sensorabschnitts wird insbesondere durch Aufbringen einer festhaftenden Schicht aus formlosem Stoff, insbesondere von einer funktionalen Tinte und/oder von einer funktionalen Farbe, auf der Oberfläche des Kontaktierungspartners oder einer vorhergehenden Schicht umgesetzt. Dadurch, dass der Sensorabschnitt durch Beschichten aufgebracht wird, nimmt dieser quasi keinen Bauraum in Anspruch, so dass bei der Anordnung des Sensorabschnitts zwischen der Batterie und dem Kontaktelement keine Störkontur entsteht, die den Fügeprozess negativ beeinflusst. Möglicherweise würde nämlich diese Positionierung jedoch dazu führen, dass das Kontaktelement von dem Pol mechanisch getrennt und/oder beabstandet wäre. Dadurch, dass der Sensorabschnitt auf mindestens einem der Kontaktierungspartner zumindest abschnittsweise oder vollständig durch Beschichten aufgebracht ist, ist dieser besonders dünn gestaltet, so dass dieser keine Störkontur zwischen dem Kontaktelement und dem Pol bildet. Somit kann die Kontaktierung zwischen dem Kontaktelement und dem Pol ungestört von dem Sensorabschnitt erfolgen, dieser jedoch trotzdem ortsnah den Fügebereich überprüfen.

Besonders bevorzugt wird der Sensorabschnitt aufgedruckt. Der Druck erfolgt insbesondere durch das Aufdrucken von der funktionalen Tinte und/oder von der funktionalen Farbe auf den jeweiligen Kontaktierungspartner. Beispielsweise erfolgt der Druckvorgang über ein Ink-Jet-Verfahren.

Es ist bevorzugt, dass der Sensorabschnitt eine Dicke von weniger als 25 µm, insbesondere von weniger als 10 µm im Speziellen weniger 1 µm aufweist. Durch diese geringe Dicke wird erreicht, dass der Sensorabschnitt auch bei einem "Nullspalt" zum Beispiel für eine Laserschweißung nicht als eine Störkontur wirkt. Vielmehr kann der durch den Sensorabschnitt begründete, geringe Abstand zwischen Pol und Kontaktelement prozesstolerant beim Fügen überbrückt werden.

Bei einer bevorzugten Ausgestaltung der Erfindung weist der Sensorabschnitt eine durch das Beschichten aufgebrachte Prüfstruktur auf, wobei die Prüfstruktur zumindest abschnittsweise elektrisch leitfähig ausgebildet ist. Insbesondere ist die Prüfstruktur metallisch realisiert. Die Prüfstruktur kann eine beliebige Auswahl an Leiterbahnen, Widerständen, Kondensatoren etc. aufweisen. Durch eine derartige Prüfstruktur kann der Sensorabschnitt in einfacher Weise an die geforderte Prüfung angepasst werden.

Optional kann der Sensorabschnitt eine Bodenschicht und/oder eine Deckschicht aufweisen, wobei die Prüfstruktur auf der Bodenschicht bzw. unter der Deckschicht angeordnet ist, so dass der Sensorabschnitt als eine Schichteinrichtung ausgebildet ist. Die Bodenschicht kann im Vergleich mit der Prüfstruktur des Sensorabschnitts weniger Details aufweisen, so dass zur Erzeugung der Bodenschicht ein weniger genaues Aufbringverfahren gewählt werden kann. So ist es beispielsweise möglich, dass die Bodenschicht aufgeklebt ist. Da aber ein derartiges Aufkleben eine Vergrößerung der Dicke des Sensorabschnitts und damit zu einer möglichen Störkontur zwischen dem Pol und dem Kontaktelement führen könnte, ist es bevorzugt, dass auch die Bodenschicht durch Beschichten, insbesondere Bedrucken aufgebracht ist. Die Bodenschicht ist insbesondere als eine Isolationsschicht und/oder als eine Haftvermittlerschicht ausgebildet. Vorzugsweise ist die Prüfstruktur auf der Bodenschicht angeordnet.

Die Batterieschichteinrichtung kann die Deckschicht aufweisen, wobei die Deckschicht auf der Prüfstruktur aufgebracht ist. Die Deckschicht kann im Vergleich mit der Prüfstruktur weniger Details aufweisen, so dass zur Erzeugung der Deckschicht ein weniger genaues Aufbringverfahren gewählt werden kann. So ist es beispielsweise möglich, dass die Deckschicht aufgeklebt ist. Aufgrund möglicher Nachteile mit der Dicke ist es, bevorzugt, dass die Deckschicht durch Beschichten, insbesondere Bedrucken aufgebracht ist.

Die Bodenschicht und/oder die Deckschicht sind vorzugsweise auf die funktional wichtigen Bereiche, z.B. zur Isolierung der Prüfstruktur begrenzt. Insbesondere kann die Bodenschicht und/oder die Deckschicht an der Fügestelle ausgespart sein, soweit diese nicht zur Isolierung der Prüfstruktur benötigt ist, um den Materialeintrag in die Fügestelle durch die Bodenschicht und/oder die Deckschicht gering zu halten.

Es ist besonders bevorzugt, dass der Sensorabschnitt, insbesondere die Prüfstruktur, mindestens einen Messbereich aufweist. Der Messbereich ist deckungsgleich und/oder überlappend und/oder umlaufend und/oder benachbart zu dem Fügebereich angeordnet. In dem Messbereich wird der Fertigungszustand der Batterieanordnung in dem Fügebereich, also lokal, geprüft. Es kann auch vorgesehen sein, dass der Sensorabschnitt mehrere derartige Messbereiche aufweist, welche mehrere Fügebereiche der Batterieanordnung prüfen. Es ist jedoch bevorzugt vorgesehen, dass die Mehrzahl der Fügebereiche einem Paar Pol - Kontaktelement zugeordnet ist.

Prinzipiell kann der Sensorabschnitt, insbesondere der Messbereich, für eine Temperaturmessung zur Messung einer Prozesstemperatur, einer Frequenzmessung zur Messung von Frequenzen z. B. bei einer Widerstandsschweißung oder Messung von anderen Prozessgrößen etc. ausgebildet sein. Durch die Erfassung von Prozessmessgrößen kann der jeweilige Fertigungszustand geprüft werden. Insbesondere werden die Prozessmessgrößen an eine Auswerteeinrichtung weitergeleitet oder von dieser abgefragt und dort in Bezug auf den Fertigungszustand der Batterieanordnung verarbeitet.

Bei einer bevorzugten Konkretisierung der Erfindung weist der Messbereich eine erste Elektrodenstruktur und eine zweite Elektrodenstruktur auf. Der Messbereich kann auf die beiden Elektrodenstrukturen begrenzt sein, alternativ können auch weitere Elektrodenstrukturen vorhanden sein. Die erste Elektrodenstruktur und die zweite Elektrodenstruktur sind in einem Ausgangszustand des Sensorabschnitts elektrisch voneinander getrennt. Der Fügebereich ist zwischen den Elektrodenstrukturen angeordnet.

Es ist bevorzugt, dass der Messbereich für eine elektrische Durchgangsmessung zu Prüfung des Fertigungszustands der Batterieanordnung in dem Fügelbereich ausgebildet ist.

Bei einer bevorzugten Realisierung ist der Messbereich für eine elektrische Durchgangsmessung zur Prüfung des Fügezustands der Batterieanordnung in dem Fügebereich ausgebildet. In dieser Realisierung wird durch einen der Kontaktierungspartner als aufgelegten Kontaktierungspartner, insbesondere durch den Kontaktierungspartner ohne Sensorabschnitt, und/oder durch den ungefügten Fügebereich ein elektrischer Durchgang in dem Messbereich erzeugt, welcher über den Sensorabschnitt ermittelbar und/oder abgreifbar ist. Insbesondere verbindet der aufgelegte Kontaktierungspartner und/oder der ungefügte Fügebereich die Elektrodenstrukturen. Sofern somit z.B. von einer möglichen Auswerteeinrichtung in dem Fügezustand ein elektrischer Durchgang in dem Messbereich ermittelt wird, wird davon ausgegangen, dass der Kontaktierungspartner so auf dem Sensorabschnitt, insbesondere auf dem Messbereich aufliegt, dass über den aufgelegten Kontaktierungspartner in dem Messbereich ein elektrischer Durchgang gebildet ist und der Kontaktierungspartner fügegerecht und/oder fügebereit aufliegt.

Alternativ oder ergänzend wird in dem Kontaktierungszustand, insbesondere von der Auswerteeinrichtung, darauf geschlossen, dass der gefügte Fügebereich den elektrischen Durchgang in dem Messbereich bildet, so dass bei einem elektrischen Durchgang auf einen korrekt gefügten Fügebereich geschlossen werden kann.

Die Auswerteeinrichtung bildet einen optionalen Bestandteil der Batterieanordnung. Die Auswerteeinrichtung kann als eine analoge und/oder digitale Datenverarbeitungseinrichtung ausgebildet sein.

Bei einer Alternative oder einer Weiterbildung der Erfindung ist der Messbereich für eine elektrische Widerstandsmessung zur Prüfung des Fertigungszustands der Batterieanordnung in dem Fügebereich ausgebildet. Die Elektrodenstrukturen bilden mehrere Einzelkontaktpaare, wobei die Einzelkontaktpaare als 1:1 Kontaktpaare insbesondere als Einzelkontaktbrücken ausgebildet sein können. Es ist möglich, dass eine Elektrodenstruktur eine Sammelelektrode für alle oder eine Teilmenge der Einzelelektrodenabschnitte der anderen Elektrodenstruktur und nur die andere Elektrodenstruktur Einzelelektrodenabschnitte aufweist. In diesem Fall bilden die Einzelelektrodenabschnitte die Einzelkontaktpaare. Es ist jedoch auch möglich, dass jede Elektrodenstruktur einen oder mehrere Sammelelektrodenabschnitte und Einzelelektrodenabschnitte aufweist, um die Einzelkontaktpaare zwischen den Elektrodenstrukturen zu bilden. Die Einzelkontaktpaare werden in Abhängigkeit des Fertigungszustands miteinander leitfähig verbunden: Ist der Fügezustand und/oder der Kontaktierungszustand sehr gut, sind alle Einzelkontaktpaare verbunden. Sind die Fertigungszustände eher grenzwertig, so sind nur wenige der Einzelkontaktpaare verbunden. Ist der Fertigungszustand mangelhaft, so sind keine Einzelkontaktpaare miteinander verbunden. Die Einzelkontaktpaare weisen jeweils mindestens oder genau einen Einzelwiderstand auf. In dem vollständig verbundenen Fertigungszustand sind die Einzelwiderstände der Einzelkontaktpaare parallel zueinander angeordnet, so dass sich aus dieser Parallelschaltung in Abhängigkeit der kontaktierten Einzelkontaktpaare ein Gesamtmessbereichswiderstand ergibt. Auf Basis des Gesamtmessbereichswiderstands kann eine Anbindungslänge in dem Fügebereich in Bezug auf den Fügezustand und/oder in Bezug auf den Kontaktierungszustand abgeschätzt werden. Insbesondere erfolgt die Abschätzung durch die Auswerteeinrichtung.

Optional ergänzend kann jeder der Einzelkontaktpaare zwei Einzelwiderstände aufweisen, wobei jedem der Elektrodenstruktur einer der Einzelwiderstände zugeordnet sind. Durch diese Weiterbildung wird erreicht, dass die einzelnen Anbindungslängen von beiden Elektrodenstrukturen mit in die Abschätzung eingehen, so dass die Anbindungslänge besser abgeschätzt werden kann.

Bei einer bevorzugten Weiterbildung der Erfindung sind die Einzelkontaktpaare über den jeweiligen Einzelwiderstand oder die jeweiligen Einzelwiderstände kodiert. Beispielsweise sind alle Einzelwiderstände von der einen und/oder der anderen Elektrodenstruktur unterschiedlich ausgebildet, wobei die Werte der Einzelwiderstände so gewählt sind, dass aus dem Gesamtmessbereichswiderstand abschätzbar ist, welche Einzelkontaktpaare elektrisch kontaktiert sind und welche Einzelkontaktpaare offen sind. In dem einfachsten Ausführungsbeispiel weist der Messbereich zwei Einzelkontaktpaare auf, welche einen unterschiedlichen Einzelwiderstand haben. Sind beide Einzelkontaktpaare geschlossen, dann gibt es einen Gesamtmessbereichswiderstand, welche aus den beiden Einzelwiderständen gebildet ist. Ist nur ein Einzelkontaktpaar geschlossen, so ergibt sich der jeweilige Einzelwiderstand des Einzelkontaktpaares. Somit können die unterschiedlichen Zustände des Messbereichs in dem Fügezustand und/oder in dem Kontaktierungszustand unterschieden werden. Insbesondere kann auf Basis des Gesamtmessbereichswiderstands eine Anbindungsverteilung geschätzt werden. Die Abschätzung erfolgt insbesondere durch die Auswerteeinrichtung. Sofern jede der Elektrodenstrukturen entsprechende kodierte Einzelwiderstände aufweist, wird erreicht, dass die einzelnen Anbindungsverteilungen von beiden Elektrodenstrukturen mit in die Abschätzung eingehen, so dass die Anbindungsverteilung besser abgeschätzt werden kann.

Bei einer möglichen konstruktiven Ausgestaltung der Erfindung weist der Sensorabschnitt mindestens einen Kontaktbereich zum Kontaktieren des Sensorabschnitts, insbesondere des Messbereichs, mit einer oder der Auswerteeinrichtung auf, wobei der Kontaktbereich auf einem der Kontaktierungspartner aufgedruckt ist. Es ist dabei sogar möglich, dass der Kontaktbereich nicht in der gleichen Ebene wie der Sensorabschnitt liegt, sondern im Rahmen von einem 3D-Druck auf einer dazu abgewandten oder parallelen Fläche angeordnet ist, um im Rahmen der Fertigung der Batterieanordnung einen einfachen Zugriff der Auswerteeinrichtung auf den Sensorabschnitt zu ermöglichen. Beispielsweise kann ein Abgriff für die Auswerteeinrichtung in einem Niederhalter von einem Werkzeug für den Fügevorgang zwischen Kontaktelement und Pol eingebracht sein, welcher beim Schließen des Werkzeugs automatisch mit dem Sensorabschnitt kontaktiert.

Der Messbereich ist bevorzugt in einem Messpfad zwischen zwei Kontaktbereichen angeordnet, so dass die Durchgangsmessung und/oder die Widerstandsmessung über die Kontaktbereiche z.B. durch die Auswerteeinrichtung durchgeführt werden kann.

Es ist besonders bevorzugt, dass der Sensorabschnitt mindestens oder genau zwei der Messbereiche aufweist. Oftmals werden der Pol mit dem Kontaktelement über mehrere Fügebereiche verbunden, wobei einigen oder jedem der Fügebereiche ein derartiger Messbereich zugeordnet ist. Die Messbereiche sind in dem Sensorabschnitt derart verschaltet, dass ein Gesamtabschnittswiderstand gebildet ist, wobei auf Basis des Gesamtabschnittswiderstands der Fertigungszustand der Batterieanordnung in dem jeweiligen Fügebereich mit den unterschiedlichen Messbereichen abschätzbar ist. Betrachtet man beispielsweise die Ausführungsform mit den kodierten Einzelwiderständen, so kann ein Messbereich mit Einzelwiderständen in einer ersten Größenordnung, z.B. in der Größenordnung von 1 kOhm, und der andere Messbereich mit Einzelwiderständen in einer zweiten Größenordnung, z.B. in der Größenordnung von 100 kOhm, also in einer anderen Größenordnung als die erste Größenordnung gestaltet werden. Die Größenordnungen können sich beispielsweise um den Faktor 10 oder mehr unterscheiden. Bereits in Abhängigkeit der Größenordnung des Gesamtabschnittswiderstands kann der Fertigungszustand der Batterieanordnung bei den jeweiligen Fügebereich und/oder bei den jeweiligen Messbereichen abgeschätzt werden.

Für den Fall, dass der Sensorabschnitt genau zwei Messbereiche aufweist, können diese, insbesondere zwischen den Kontaktbereichen, in Reihe geschaltet werden und einen Messpfad bilden, wobei eine Durchgangsmessung nur dann einen elektrischen Durchgang und damit eine fügebereite und/oder fügegerechte Anordnung des Kontaktelements auf dem Pol in dem Fügezustand und/oder eine stoffschlüssige Verbindung von Kontaktelement und Pol in dem Kontaktierungszustand ergibt, wenn beide Messbereiche elektrisch verbunden sind.

Wenn die genau zwei Messbereiche für eine elektrische Widerstandsmessung zur Prüfung des Fertigungszustands der Batterieanordnung in dem Fügebereich ausgebildet sind, können diese wahlweise in einem Messpfad in Reihe geschaltet werden oder - soweit sich die Einzelwiderstände der Messbereiche ausreichend unterscheiden - auch parallel in zwei Messpfaden geschaltet werden, um eine fügebereite und/oder fügegerechte Anordnung des Kontaktelements auf dem Pol in dem Fügezustand und/oder eine stoffschlüssige Verbindung von Kontaktelement und Pol in dem Kontaktierungszustand erfassen. In dieser Ausgestaltung bilden die zwei Messbereiche ein Widerstandsnetzwerk.

Bei einer bevorzugten Weiterbildung der Erfindung sind die Messbereiche in einem oder dem Widerstandsnetzwerk angeordnet und/oder bilden - wie soeben dargelegt - ein oder das Widerstandsnetzwerk mit. In dem Widerstandsnetzwerk können eine Vielzahl, z.B. zwei, drei, vier, fünf oder mehr Messpfade vorgesehen sein. In dem Widerstandsnetzwerk sind unterschiedliche Messpfade durch Pfadwiderstände kodiert. Alternativ oder ergänzend weisen die Messbereiche die Einzelwiderstände auf, so dass aus den Komponenten des Widerstandsnetzwerks der Gesamtabschnittswiderstand gebildet ist. Neben der Kodierung der Messbereiche über die Einzelwiderstände ist es somit möglich, auch in den Messpfaden jeweils einen oder mehrere Pfadwiderstände einzubringen, so dass die verschiedenen Messpfade unterschieden werden können. Beispielsweise werden die Messbereiche zwischen zwei Kontaktbereichen des Sensorabschnitts elektrisch parallel angeordnet, wobei jeder Parallelpfad einen Messpfad bildet, welcher über einen Pfadwiderstand kodiert ist. Optional und für die Prüfung des Fügezustands sind auf dem auf den Sensorabschnitt anzupressenden Kontaktierungspartner leitende Pads angeordnet, die von dem leitenden Basismaterial des Kontaktierungspartner isoliert sind. Z.B. ist ein Aufdruck auf dem Kontaktierungspartner, der gefügt werden soll, notwendig. Auf diese Weise wird erreicht, dass sich Kurzschlüsse zwischen den Messbereichen durch oder über das Basismaterial des anzupressenden Kontaktierungspartner nicht ergeben können. Die Pads weisen bevorzugt jeweils eine isolierende Bodenschicht und eine elektrisch leitende Deckschicht auf. Insbesondere sind die Pads oder zumindest die elektrisch leitende Deckschicht jeweils auf einen Messbereich oder Fügebereich begrenzt.

Alternativ oder ergänzend ist in jedem Messpfad vor jedem Messbereich und nach jedem Messbereich ein Pfadwiderstand angeordnet. Die Pfadwiderstände der verschiedenen Messpfade sind unterschiedlich ausgebildet, so dass der jeweilige Messpfad über die Kombination der Pfadwiderstände eindeutig kodiert ist und/oder so dass über den Gesamtwiderstand auf den Fügezustand der Fügebereiche geschlossen werden kann. Insbesondere kann der Messpfad im Vergleich zum Widerstand des Fügebereichs deutlich größere Widerstandswerte aufweisen, z.B. mind. 10-fach, mind. 100-fach oder mehr. Alternativ oder ergänzend jedoch kleiner als der parasitäre Widerstand ohne aufgelegtem Fügepartner oder die gefügte Verbindung.

Besonders bevorzugt weist jeder der Messpfade einen Messbereich sowie einen davor und einen danach angeordneten Pfadwiderstand auf, wobei die Pfadwiderstände die Messpfade eindeutig kodieren. Bei einer möglichen Ausgestaltung sind die Messpfade, insbesondere alle Messpfade oder eine Teilmenge davon, elektrisch parallel zueinander angeordnet.

Sollen mehr als zwei Messbereiche in dem Widerstandsnetzwerk angeordnet werden, so ist es bevorzugt, dass in jedem Messpfad maximal zwei Messbereiche angeordnet sind. Auf diese Weise ist sichergestellt, dass jeder der Messbereiche sicher erfasst wird, ohne über eine Kurzschlussverbindung über einen der Kontaktierungspartner einen Messbereich zu übersehen.

Alternativ ist in jeder Verbindung zwischen zwei Messbereichen in einem Messpfad ein Widerstand ausgebildet, der durch die Einzelwiderstände oder durch einen Pfadwiderstand gebildet ist und dadurch einen Messpfadabschnitt kodiert.

Für den Fall, dass der Kontaktierungspartner eine metallische Oberfläche oder leitende Oberfläche aufweist, ist es bevorzugt, dass der Sensorabschnitt die isolierende Bodenschicht aufweist, über die die Prüfstruktur von dem Kontaktierungspartner, auf dem die Prüfstruktur aufgedruckt ist, elektrisch isoliert ist.

Für den Einsatz des Sensorabschnitts zur Überprüfung des Fügezustands ist es bevorzugt, dass der Sensorabschnitt im Ausgangszustand, insbesondere im Fügebereich und/oder Messbereich, zumindest abschnittsweise kontaktfähig ausgebildet ist, so dass der Sensorabschnitt in dem Fügezustand mit dem aufgelegten Kontaktierungspartner elektrisch kontaktieren kann, um den Fügezustand zu prüfen. Vereinfacht gesagt wird der Kontaktierungspartner auf den anderen Kontaktierungspartner bzw. auf den Kontaktierungspartner mit dem Sensorabschnitt aufgelegt, so dass insbesondere in dem Messbereich ein elektrischer Durchgang geschlossen ist. Dies wird dadurch ermöglicht, dass der Sensorabschnitt, insbesondere der Messbereich, abschnittsweise kontaktfähig ist.

Dagegen ist es bei dem Einsatzgebiet des Sensorabschnitts zur Überprüfung des Kontaktierungszustands bevorzugt, dass der Sensorabschnitt in dem Fügezustand und/oder in dem Ausgangszustand, insbesondere im Fügebereich und/oder Messbereich, zumindest abschnittsweise gegenüber dem aufgelegten Kontaktierungspartner elektrisch isoliert ist. Dadurch wird verhindert, dass bereits in dem Fügezustand ein elektrischer Durchgang oder Ähnliches geschaffen wird. Es ist jedoch vorgesehen, dass der Sensorabschnitt in dem Kontaktierungszustand in Abhängigkeit des Kontaktierungszustands in dem Messbereich elektrisch verbunden ist, um den Kontaktierungszustand zu prüfen. Insbesondere ist vorgesehen, dass durch den Fügeprozess zum einen die Kontaktierungspartner miteinander stoffschlüssig verbunden werden und zum anderen durch das stoffschlüssige Verbinden die elektrische Isolierung aufgelöst wird und eine elektrische Verbindung zwischen den Elektrodenstrukturen in dem Messbereich erfolgt, so dass der Kontaktierungszustand geprüft werden kann.

Ein weiterer Gegenstand der Erfindung betrifft ein Batteriesystem, wobei das Batteriesystem eine Vielzahl der Batterieanordnungen aufweist, wie diese zuvor beschrieben wurde bzw. nach einem der vorhergehenden Ansprüche. Das Batteriesystem kann beispielsweise als ein Batteriesystem für einen elektrischen Antrieb eines Fahrzeugs ausgebildet sein. Es kann jedoch auch als ein stationärer oder mobiler Energiespeicher ausgebildet sein. Prinzipiell kann das Batteriesystem wenige Batterieanordnungen aufweisen, z.B. mehr als 2, 3, 4 oder 5. Die Batterie kann als ein gerader Zylinder, insbesondere Kreiszylinder ausgebildet sein. Insbesondere bildet die Batterie eine Rundzelle. Alternativ ist die Batterie rechteckig oder quaderförmig ausgebildet. Insbesondere kann die Batterie als "Blade" ausgebildet sein, welches als schmaler Quader ausgebildet ist. Vorzugsweise weist das Batteriesystem mindestens 50, insbesondere mindestens 80, im Speziellen mindestens 100 der Batterieanordnungen auf, insbesondere in der Ausbildung als Zylinder auf. In dem Fall, dass statt zylindrischer Zellen Zellen mit rechteckigem Format verwendet werden, kann die Anzahl kleiner sein, also weniger als 50, sollte mindestens jedoch 6 oder 10 oder 16 betragen. Bevorzugt weist das Batteriesystem größtenteils oder ausschließlich Batterieanordnungen auf, so dass ein Großteil oder alle Batterien kontrolliert sind. Gerade im Bereich der power tools, Consumer-Bereich oder dergleichen kann das Batteriesystem weniger als 10 Batterieanordnungen, im Speziellen weniger als 5 Batterieanordnungen aufweisen. Denkbar sind z. B. mindestens oder genau drei Batterieanordnungen (insbesondere für 12V-Batteriesysteme) oder mindestens oder genau vier Batterieanordnungen (insbesondere für 24V-Batteriesysteme), oder mindestens oder genau acht Batterieanordnungen (insbesondere für 48V-Batteriesysteme) oder Batteriesysteme mit nur zwei Batterieanordnungen.

Ein weiterer Gegenstand der Erfindung betrifft ein Verfahren zum Prüfen des Fertigungszustands einer Batterieanordnung, wie diese zuvor beschrieben wurde bzw. nach einem der vorhergehenden Ansprüche. Es ist vorgesehen, dass die Batterieanordnung in einen der Fertigungszustände gebracht wird und der Fertigungszustand der Batterieanordnung über den Sensorabschnitt geprüft wird.

Weitere Merkmale, Vorteile und Wirkungen der Erfindung ergeben sich aus der nachfolgenden Beschreibung bevorzugter Ausführungsbeispiele der Erfindung. Dabei zeigen:
- Figur 1: eine schematische, dreidimensionale Darstellung von einer Batterieanordnung als ein Ausführungsbeispiel der Erfindung;
- Figur 2: ein schematischer Längsschnitt durch die Batterieanordnung der Figur 1 ;
- Figuren 3 a-h: verschiedene Varianten für einen Messbereich in einem Sensorabschnitt in der Batterieanordnung der vorhergehenden Figuren;
- Figur 4: ein erstes Ausführungsbeispiel für einen Sensorabschnitt für die Batterieanordnung der vorhergehenden Figuren.
- Figur 5: ein zweites Ausführungsbeispiel für einen Sensorabschnitt für die Batterieanordnung der vorhergehenden Figuren
- Figur 6: ein drittes Ausführungsbeispiel für einen Sensorabschnitt für die Batterieanordnung der vorhergehenden Figuren
- Figur 7: ein viertes Ausführungsbeispiel für einen Sensorabschnitt für die Batterieanordnung der vorhergehenden Figuren
- Figur 8: ein fünftes Ausführungsbeispiel für einen Sensorabschnitt für die Batterieanordnung der vorhergehenden Figuren
- Figur 9: ein sechstes Ausführungsbeispiel für einen Sensorabschnitt für die Batterieanordnung der vorhergehenden Figuren
- Figur 10: ein siebtes Ausführungsbeispiel für einen Sensorabschnitt für die Batterieanordnung der vorhergehenden Figuren
- Figur 11: ein achtes Ausführungsbeispiel für einen Sensorabschnitt für die Batterieanordnung der vorhergehenden Figuren
- Figur 12: eine schematische, dreidimensionale Darstellung auf ein Kontaktelement der Batterieanordnung.

Einander entsprechende oder gleiche Teile sind in den Figuren jeweils mit den gleichen Bezugszeichen versehen.

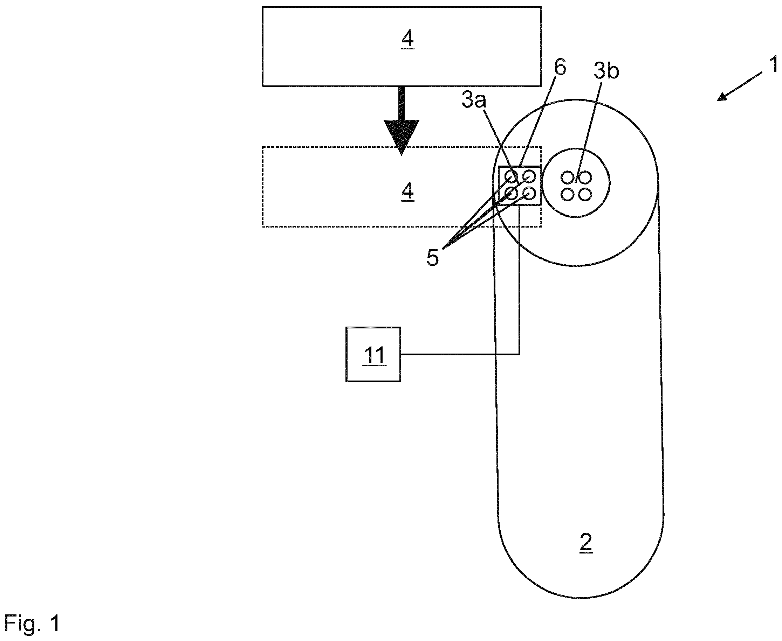

Die Figur 1 zeigt in einer stark schematisierten, dreidimensionale Ansicht eine Batterieanordnung 1 als ein Ausführungsbeispiel der Erfindung. Die Batterieanordnung 1 weist eine Batterie 2 auf, welcher als eine Einfachzelle oder als eine Mehrfachzelle ausgebildet ist. Die Batterie 2 weist bei diesem Ausführungsbeispiel zwei Pole 3 a, b auf, über die die Batterie 2 mit einer Verbraucherstruktur kontaktiert werden kann. Ferner weist die Batterieanordnung 1 ein Kontaktelement 4 auf, welches beispielsweise als ein Metallstreifen ausgebildet ist und welches einen der zwei Pole 3 a, b kontaktieren soll, um die Batterie 2 mit der Verbraucherstruktur elektrisch zu verbinden.

Die Kontaktierung des Kontaktelements 4 an den - beispielhaft genannten - Pol 3 a wird über beispielhaft vier Fügebereiche 5 umgesetzt, wobei zur Kontaktierung auch nur ein Fügebereich 5 oder mehr Fügebereiche 5 vorgesehen sein können. Die Kontaktierung erfolgt über ein stoffschlüssiges Fügeverfahren, insbesondere ohne Zusatzwerkstoff. Beispielhaft erfolgt das Fügeverfahren über ein Metallschmelzverfahren, wie zum Beispiel Schweißen oder Löten. Beispielsweise wird das Kontaktelement 4 an den Fügebereich 5 des Pols 3 a über Ultraschallschweißen, Widerstandsschweißen oder Laserstrahlschweißen stoffschlüssig und elektrisch kontaktierend befestigt. Der Pol 3 a bildet einen ersten Kontaktierungspartner, das Kontaktelement 4 bildet einen zweiten Kontaktierungspartner.

Der Fügebereich 5 wird durch die Kontaktierungspartner gebildet. Unter dem Fügebereich 5 kann zum einen der zu fügende Bereich, also vor der stoffschlüssigen Verbindung zwischen den Kontaktierungspartner, und zum anderen der gefügte Bereich, nach der stoffschlüssigen Verbindung der Kontaktierungspartner, verstanden werden.

Auf einem der Kontaktierungspartner ist ein Sensorabschnitt 6 aufgedruckt. Dabei kann vorgesehen sein, dass der Sensorabschnitt 6 auf dem Pol 3 a und/oder auf dem Kontaktelement 4 aufgedruckt ist
Der Sensorabschnitt 6 hat die Funktion, den Fertigungszustand der Batterieanordnung 1 zu überprüfen. In Abhängigkeit der Ausgestaltung kann der Sensorabschnitt 6 die Batterieanordnung 1 in einem Fügezustand als Fertigungszustand überprüfen, ob die Kontaktierungspartner fügebereit und/oder fügegerecht angeordnet sind, um nachfolgend einen fehlerfreien Fügevorgang durchzuführen.

Alternativ oder ergänzend kann der Sensorabschnitt 6 einen Kontaktierungszustand der Batterieanordnung 1 als Fertigungszustand überprüfen, ob das Kontaktelement 4 mit dem Pol 3 a in einem der Fügebereiche 5 stoffschlüssig und damit elektrisch leitend verbunden ist.

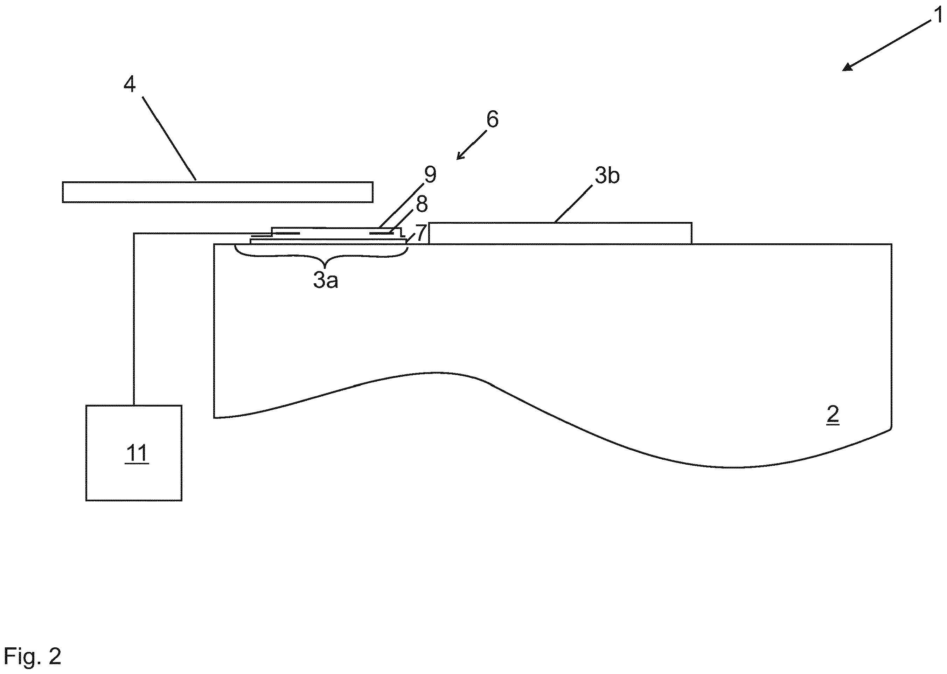

Die Figur 2 zeigt eine schematische Schnittansicht der Batterieanordnung 1, wobei die Batterie 2 mit dem Pol 3 a, b sowie das Kontaktelement 4 dargestellt sind. Aus der Darstellung ist zu entnehmen, dass der Sensorabschnitt 6 zwischen den Kontaktierungspartner, also dem Pol 3 a und dem Kontaktelement 4 angeordnet ist. Bei der Kontaktierung des Kontaktelements 4 mit dem Pol 3 a darf jedoch ein Fügespalt zwischen dem Kontaktelement 4 und dem Pol 3 oder allgemein den Kontaktierungspartner nur sehr klein bemessen sein, um eine funktionsgerechte Kontaktierung zu ermöglichen. Der Sensorabschnitt 6, welcher in dem Fügespalt zwischen den Kontaktierungspartner angeordnet ist, weist eine geringe Dicke auf, wobei die geringe Dicke durch das Aufdrucken des Sensorabschnitts 6 ermöglicht ist. Die Dicke des Sensorabschnitts 6 beträgt insbesondere weniger als 25 µm, insbesondere weniger als 10 µm und im Speziellen weniger als 1 µm in dem Fügespalt. Durch diese geringe Dicke und die geringen Materialmengen kann der Fügeprozess trotz dem Sensorabschnitt 6 prozessgerecht durchgeführt werden.

In dem gezeigten Querschnitt ist zu erkennen, dass der Sensorabschnitt 6 eine Bodenschicht 7 aufweist, über die der Sensorabschnitt 6 auf dem Kontaktierungspartner, hier dem Pol 3 a aufgedruckt ist. Als funktionale Schicht weist der Sensorabschnitt 6 eine aufgedruckt Prüfstruktur 8 auf, welche nachfolgend noch genauer beschrieben wird und welche mittels einer leitfähigen Tinte oder Farbe aufgedruckt wurde. Optional ist der Sensorabschnitt 6 bereichsweise mit einer Deckschicht 9 versehen, welche die Prüfstruktur 8 zumindest abschnittsweise gegenüber dem aufliegenden Kontaktierungspartner, in diesem Ausführungsbeispiel gegenüber dem Kontaktelement 4, elektrisch isoliert. Die Bodenschicht 7 kann entweder als eine Haftverbesserung ausgebildet sein und/oder kann eine elektrische Isolierung zu dem anderen Kontaktierungspartner, hier dem Pol 3 a, bilden. Die Bodenschicht 7 und/oder die Deckschicht 9 kann nur abschnittsweise ausgebildet sein und insbesondere die Fügebereich 5 freilassen, um einen Einfluss auf die Qualität des gefügten Fügebereichs durch eine Materialbeimischung durch die Bodenschicht 7 und/oder Deckschicht 9 zu vermeiden. Soweit das Material der Bodenschicht 7 und/oder Deckschicht 9 fügefreundlich ist und keinen negativen Einfluss auf die Qualität des gefügten Fügebereichs 5 hat, kann die Bodenschicht 7 und/oder Deckschicht 9 auch vollflächig aufgebracht sein.

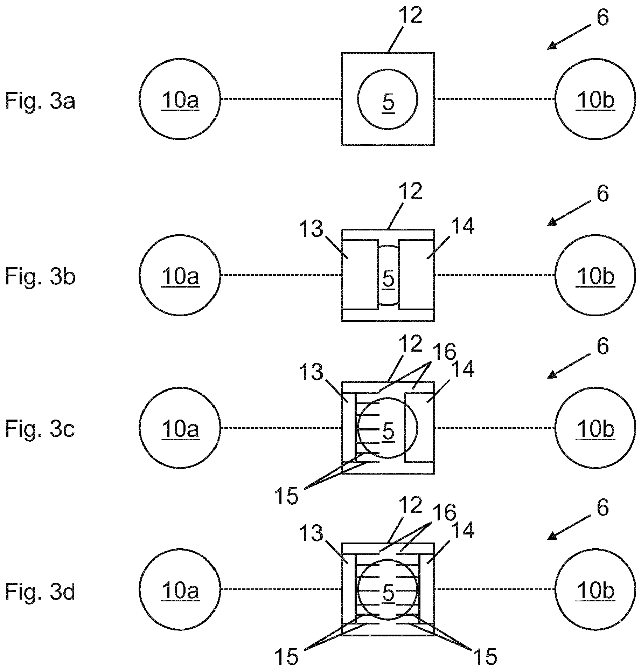

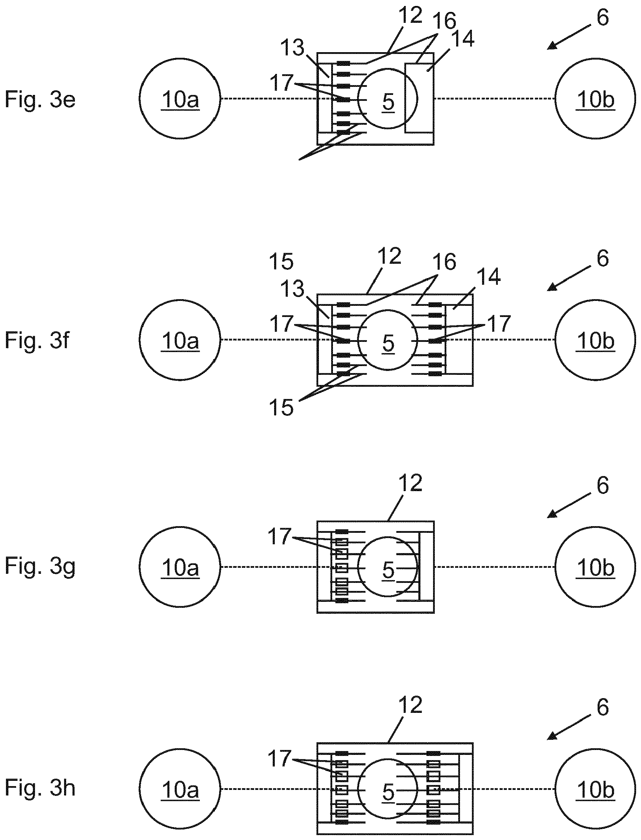

Die Figuren 3 a - f zeigen verschiedene Ausführungsbeispiele für den Sensorabschnitt 6. Der Sensorabschnitt 6 weist zwei Kontaktbereiche 10 a, b auf über die ein Sensorsignal aus dem Sensorabschnitt 6 abgeleitet werden kann.

Beispielsweise und wie in den Figuren 2 zu erkennen umfasst die Batterieanordnung 1 eine Auswerteeinrichtung 11, welche mit den Kontaktbereichen 10 a, b kontaktieren kann, um das Sensorsignal abzuleiten. Der Sensorabschnitt 6 ist insbesondere als ein passiver Sensorabschnitt ausgebildet, so dass die Auswerteeinrichtung 11 diesen beispielsweise mit einer Prüfspannung und/oder mit einem Prüfstrom beaufschlagt.

Der Sensorabschnitt 6 weist mindestens einen Messbereich 12 auf, wobei der Messbereich 12 deckungsgleich und/oder überlappend und/oder unmittelbar angrenzend zu dem Fügebereich 5 angeordnet ist. Dadurch, dass der Messbereich 12 unmittelbar an dem Fügebereich 5 angeordnet ist, kann dieser lokal durch den Messbereich 12 überprüft werden. Die Überprüfung kann sowohl in Fügezustand als auch im Kontaktierungszustand der Batterieanordnung 1 durchgeführt werden. Die Figur 3 a zeigt den allgemeinen Aufbau des Sensorabschnitts 6. Die gestrichelten Linien zwischen dem Messbereich 12 und den Kontaktbereichen 10 a, b deuten an, dass weitere elektrische Elemente, insbesondere Widerstände, oder Messbereiche 12 in dem Sensorabschnitt 6 realisiert sein können.

Die Figur 3 b zeigt in einer schematischen Darstellung eine erste mögliche Realisierung von dem Messbereich 12. Der Messbereich 12 weist eine erste Elektrodenstruktur 13 und eine zweite Elektrodenstruktur 14 auf, wobei die erste Elektrodenstruktur 13 mit dem Kontaktbereich 10 a und die zweite Elektrodenstruktur 14 mit dem Kontaktbereich 10 b leitend verbunden sind. Bei dem Ausführungsbeispiel der Figur 3 b sind die Elektrodenstrukturen 13, 14 jeweils als ein rechteckiger Elektrodenabschnitt ausgebildet. Optional kann der Elektrodenabschnitt auch an die Form des Fügebereichs 5 angepasst sein und beispielsweise halbrund ausgeschnitten sein

In dem Fügezustand liegen die Kontaktierungspartner somit fügebereit und/oder fügegerecht in dem Fügebereich 5 aneinander, wobei der aufliegende Kontaktierungspartner die Elektrodenstrukturen 13, 14 elektrisch miteinander verbindet, so dass die Überprüfung von dem Fügezustand durch eine Durchgangsprüfung erfolgen kann. Sobald von der Auswerteeinrichtung 11 ein elektrischer Durchgang zwischen den Elektrodenstrukturen 13, 14 detektiert wird, sind die Kontaktierungspartner fügebereit/oder fügegerecht angeordnet.

In dem Kontaktierungszustand ist der Fügebereich 5 stoffschlüssig gefügt, wobei die Elektrodenstrukturen 13, 14 durch den stoffschlüssig gefügten Fügebereich 5 miteinander elektrisch leitfähig verbunden sind. Auf diese Weise kann die Auswerteeinrichtung 11 den Kontaktierungszustand der Batterieanordnung 1 in dem Fügebereich 5 ebenfalls mittels einer Durchgangsmessung prüfen.

Die Figur 3 c zeigt eine alternative Ausführungsform, wobei die erste Elektrodenstruktur 13 eine Mehrzahl von Einzelelektrodenabschnitten 15 aufweist. Die Einzelelektrodenabschnitte 15 erstrecken sich parallel zueinander. Durch diese Ausgestaltung wird der Fügebereich 15 durch die erste Elektrodenstruktur 13 weniger beeinträchtigt.

In der Figur 3 d ist ein Ausführungsbeispiel gezeigt, wobei beide Elektrodenstrukturen 13, 14 entsprechende Elektrodenabschnitte 15 aufweisen.

Sowohl bei dem Ausführungsbeispiel in der Figur 3 c als auch bei dem Ausführungsbeispiel in der Figur 3 d werden Einzelkontaktpaare 16 gebildet, wobei die Einzelkontaktpaare 16 unabhängig voneinander durch den Fügebereich 5 und/oder den aufliegenden Kontaktierungspartner elektrisch verbunden können. Bei dem Ausführungsbeispiel in der Figur 3 c wird ein Einzelkontaktpaar 16 jeweils durch einen Einzelelektrodenabschnitt 15 der ersten Elektrodenstruktur 13 und die gegenüberliegende zweite Elektrodenstruktur 14 gebildet. Bei dem Ausführungsbeispiel in der Figur 3 d wird ein Einzelkontaktpaar 16 jeweils durch einen Einzelelektrodenabschnitt 15 der ersten Elektrodenstruktur 13 und ein gegenüberliegender Einzelelektrodenabschnitt 15 der gegenüberliegenden zweiten Elektrodenstruktur 14 gebildet.

In der Figur 3 e weist jeder der Elektrodenabschnitte 15 der ersten Elektrodenstruktur 13 einen Widerstand 17 auf, so dass in dem Fügezustand und/oder in dem Kontaktierungszustand mehrere der Einzelkontaktpaare 16 miteinander leitend verbunden sind und dadurch eine Parallelschaltung mit den Einzelwiderständen 17 bilden.

An den Ausgängen des Messbereichs 12 ergibt sich ein Gesamtmessbereichswiderstand, wobei der Gesamtmessbereichswiderstand durch die parallele Schaltung der Einzelwiderstände 17 gebildet ist. Der Gesamtmessbereichswiderstand ist somit davon abhängig, wie viele Einzelkontaktpaare 16 miteinander leitfähig in Verbindung stehen.

Die Auswerteeinrichtung 11 ist ausgebildet, auf Basis des Gesamtmessbereichswiderstands eine Anbindungslänge in dem Fügebereich 5 abzuschätzen. Ist die Anbindungslänge gering, so sind wenige Einzelkontaktepaare 16 miteinander elektrisch leitend verbunden und der Gesamtmessbereichswiderstand ist groß, ggf. entspricht dieser einem Einzelwiderstand 17. Ist die Anbindungslänge größer, so sind mehr der Einzelkontaktpaare 16 miteinander verbunden und es ergibt sich ein kleinerer Gesamtmessbereichswiderstand. Die Anbindungslänge kann dabei sowohl in dem Fügezustand als auch in dem Kontaktierungszustand abgeschätzt werden.

In der Figur 3f ist ein Ausführungsbeispiel gezeigt, wobei auch die zweite Elektrodenstruktur 14 Einzelwiderstände 17 aufweist. In diesem Ausführungsbeispiel kann die Anbindungslänge besser abgeschätzt werden, da auch durch die zweite Elektrodenstruktur 14 mit den Einzelwiderständen 17 eine Änderung des Gesamtmessbereichswiderstands in Anhängigkeit der Anbindungslänge erzeugt wird.

In der Figur 3 g ist ein weiteres Ausführungsbeispiel gezeigt, wobei die Einzelwiderstände 17 unterschiedlich groß sind und dadurch kodiert sind. Durch eine entsprechende Wahl der Werte für die Einzelwiderstände 17 kann somit nicht nur eine Anbindungslänge abgeschätzt werden, es kann vielmehr abgeschätzt werden, welche der Einzelkontaktepaare 16 miteinander elektrisch leitend verbunden sind und dadurch eine Anbindungsverteilung abgeschätzt werden, indem über den Gesamtmessbereichswiderstand die Einzelkontaktpaare 16 identifiziert werden, welche elektrisch leitend miteinander verbunden sind.

In der Figur 3h in ein Ausführungsbeispiel gezeigt, wobei auch die zweite Elektrodenstruktur 14 kodierte Einzelwiderstände 17 aufweist. In diesem Ausführungsbeispiel kann die Anbindungsverteilung besser abgeschätzt werden, da auch durch die zweite Elektrodenstruktur 14 mit den kodierten Einzelwiderständen 17 eine Änderung des Gesamtmessbereichswiderstands in Anhängigkeit der Anbindungsverteilung erzeugt wird.

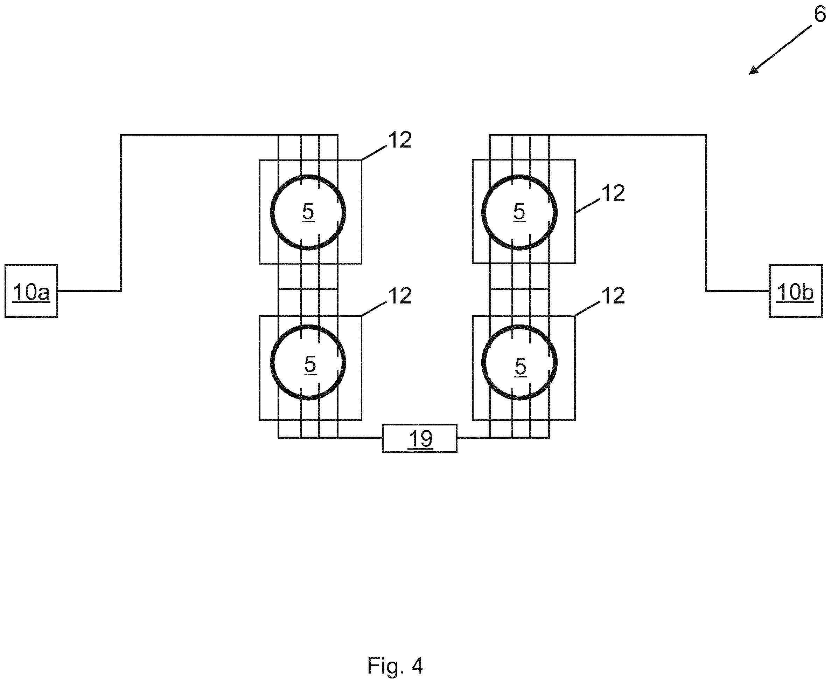

In der Figur 4 ist ein Ausführungsbeispiel des Sensorabschnitts 6 gezeigt, welcher simultan und/oder zeitgleich vier Fügebereiche 5 von dem Pol 3 a überprüfen kann. Der Sensorabschnitt 6 weist vier Messbereiche 12 auf, wie diese in der Figur 3 d beschrieben wurden, welche in Reihe geschaltet sind. Nach den ersten zwei Messbereichen 12 ist ein Pfadwiderstand 19 in Reihe in dem Messpfad 18 zur Kodierung des nachfolgenden Messpfadabschnitts eingefügt. Für den Fall, dass nur einer der Fügebereiche 5 entweder in dem Fügezustand nicht fügegerecht und/oder fügebereit positioniert ist, so ist der elektrische Pfad zwischen den Kontaktbereichen 10 a, b über den Pfadwiderstand 19 unterbrochen, und die Auswerteeinrichtung 11 kann keinen, von dem Pfadwiderstand 19 abhängigen Gesamtabschnittswiderstandmessen, so dass die Fehlpositionierung erkannt wird. Hierbei sind auf dem auf den Sensorabschnitt 6 anzupressenden Kontaktierungspartner leitende Pads angeordnet, die von dem leitenden Basismaterial des Kontaktierungspartner isoliert sind. Z.B. ist ein Aufdruck auf dem Kontaktierungspartner, der gefügt werden soll, notwendig. Auf diese Weise wird erreicht, dass sich Kurzschlüsse zwischen den Messbereichen 12 durch oder über das Basismaterial des anzupressenden Kontaktierungspartner nicht ergeben können.

Die Pads weisen somit jeweils eine isolierende Bodenschicht und eine elektrisch leitende Deckschicht auf. Insbesondere sind die Pads jeweils auf einen Messbereich 12 oder Fügebereich 5 begrenzt.

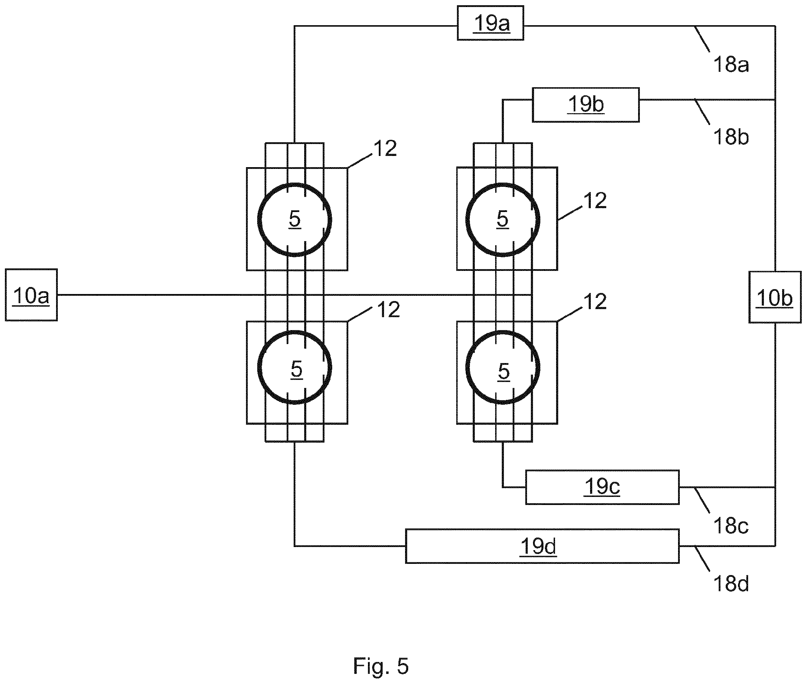

Die Figur 5 zeigt in gleicher schematischer Darstellung einen Sensorabschnitt 6 als ein Ausführungsbeispiel mit vier Messbereichen 12, wie diese in der Figur 3 b dargestellt sind, wobei die Messbereiche 12 in einem Widerstandsnetzwerk angeordnet sind. Das Widerstandsnetzwerk weist für jeden Messbereich 12 einen Messpfad 18 a, b, c, d auf, welche elektrisch parallel zueinander geschalten sind. In jedem Widerstandspfad 18 a, b, c, d befindet sich ein Pfadwiderstand 19 a, b, c, d, wobei die Pfadwiderstände 19 a, b, c, d als unterschiedlich Widerstände ausgebildet sind. Durch die unterschiedliche Wahl der Werte für die Pfadwiderstände 19 a, b, c, d sind die Messpfade 18 a, b, c, d kodiert, so dass die Auswerteeinrichtung 11 abschätzen kann, welche der Fügebereiche 5 ggf. fehlerhaft in dem Fügezustand ist. Für den Fall, dass einer der Fügebereiche 5 im Fügezustand nicht fehlerfrei ist, wird der entsprechende Messpfad 18 a, b, c, d durch den Messbereich 12 nicht leitfähig geschalten, so dass sich an den Kontaktbereichen 10, a, b ein geänderter Gesamtabschnittswiderstand ergibt. Die Auswerteeinrichtung 11 ist ausgebildet, auf Basis des Gesamtabschnittswiderstands abzuschätzen welcher Messpfad 18 a, b, c, d und damit welcher Messbereich 12 leitend geschalten ist und kann damit den Fertigungszustand der Batterieanordnung 1 in den Fügebereichen 5 abschätzen.

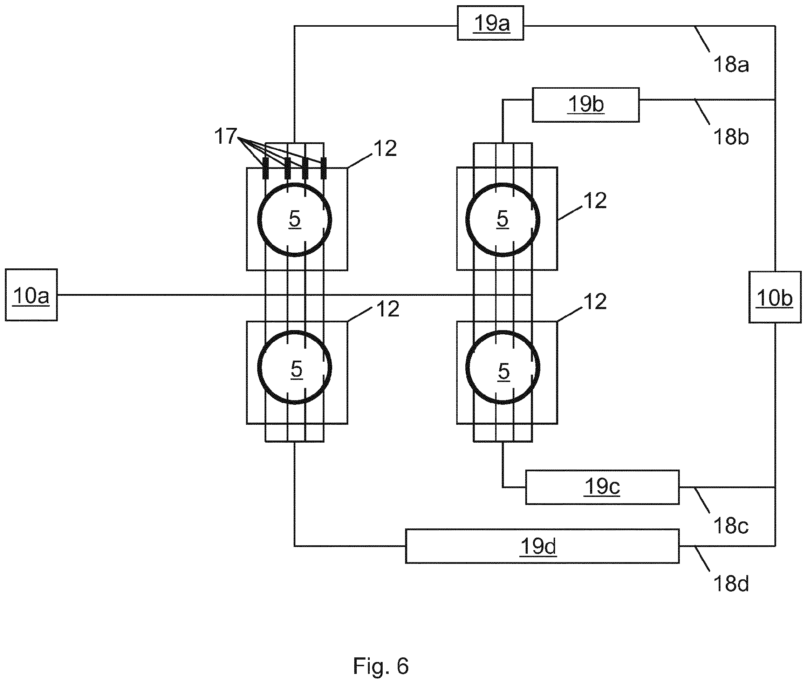

Die Figur 6 zeigt eine Abwandlung des Ausführungsbeispiels des Sensorabschnitts 6 in der Figur 5, wobei einer der Messbereiche 12 so ausgebildet ist, wie dieses in den Figuren 3 e oder 3 f dargestellt ist. In dieser Ausgestaltung ermöglicht es der Sensorabschnitt 6 nicht nur einen absoluten elektrischen Durchgang für jeden Messbereich 12 und damit für jeden Fügebereich 5 zu ermitteln, sondern es kann - wie zuvor in Zusammenhang mit den Figur 3 e und 3 f beschrieben - auch die jeweilige Anbindungslänge und/oder die jeweilige Anbindungsverteilung für den Messbereich 12 mit den Einzelwiderständen 17 durch die Auswerteeinrichtung 11 abgeschätzt werden.

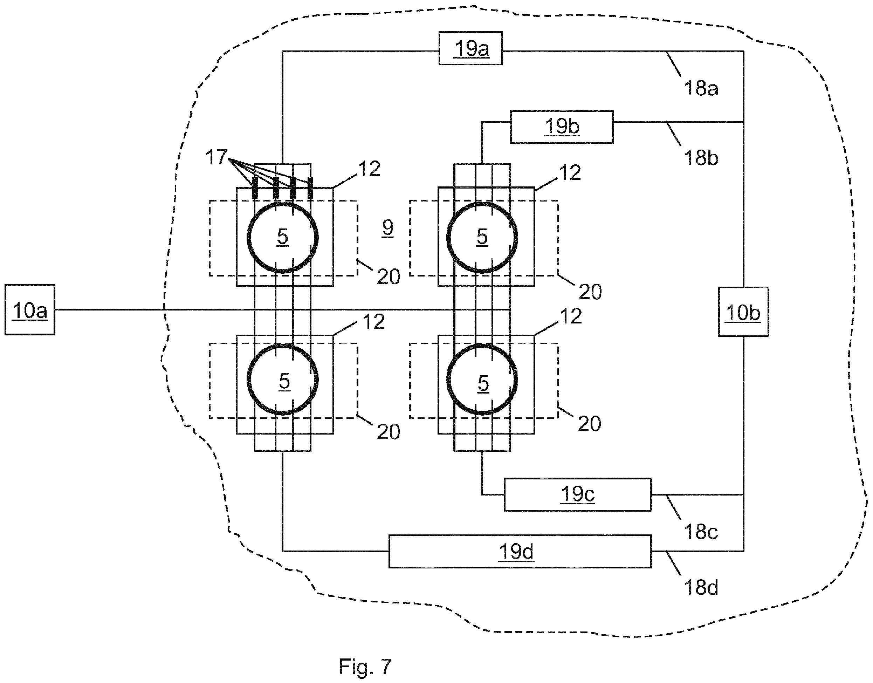

Die Figur 7 zeigt eine Abwandlung von dem Sensorabschnitt 6 in der Figur 6, wobei schematisiert die Deckschicht 9 dargestellt ist. Der Sensorabschnitt 6 und insbesondere die Messbereiche 12 sind für eine Prüfung in dem Fügezustand der Batterieanordnung 1 speziell ausgebildet. Die Messbereiche 12 sind im Bereich der jeweiligen Fügebereiche 5 abschnittsweise kontaktfähig ausgebildet, in dem die isolierende Deckschicht 9 entsprechende Freibereiche 20 aufweist, so dass der Sensorabschnitt 6, insbesondere der jeweilige Messbereich 12 in dem Fügezustand mit dem aufgelegten Kontaktierungspartner elektrisch kontaktieren kann, um den Fügezustand zu prüfen.

Bei den Ausführungsbeispielen in der Figuren 5 bis 7 weist der anzupressende Kontaktierungspartner jeweils einen Pad für jeden Messbereich 12 und/oder für jeden Fügebereich 5 auf, um einen Kurzschluss zu vermeiden. In diesen Ausgestaltungen kann der Fügezustand kontrolliert werden. Die Kontrolle des Kontaktierungszustands ist aufgrund entstehender Kurzschlüsse über den Kontaktierungspartner, der die Messbereich 12 trägt, nicht oder nicht vollständig aussagekräftig.

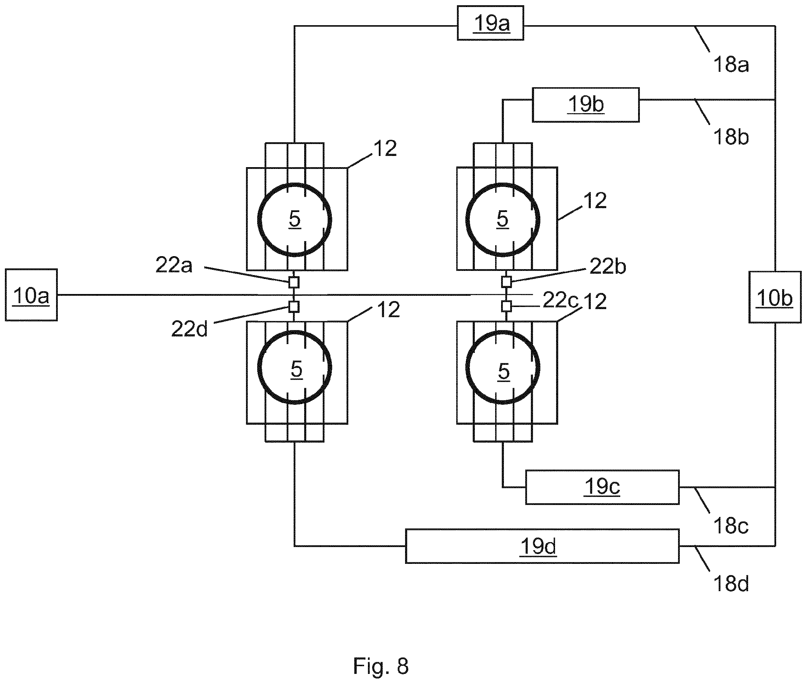

Die Figur 8 zeigt das Ausführungsbeispiel aus der Figur 5, wobei vor jedem Messbereich 12 ein weiterer Pfadwiderstand 22 a, b, c, d angeordnet ist, wobei die weiteren Pfadwiderstände unterschiedlich ausgebildet sind. Insbesondere sind Pfadwiderstände 19 a, b, c, d als nachlaufende Widerstände und die weiteren Pfadwiderstände 22 a, b, c, d als vorlaufende Widerstände in Bezug auf die Messbereiche 12 angeordnet. Durch diese erweiterte Kodierung ist es möglich, insbesondere auch ohne Verwendung von Pads, den Fügezustand und/oder den Kontaktierungszustand von allen Messbereichen 12 zu prüfen.

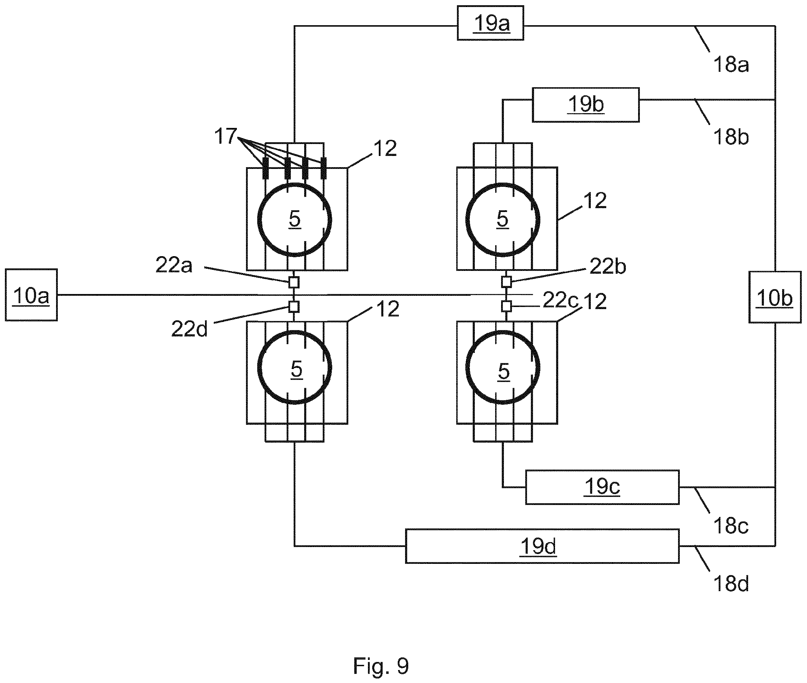

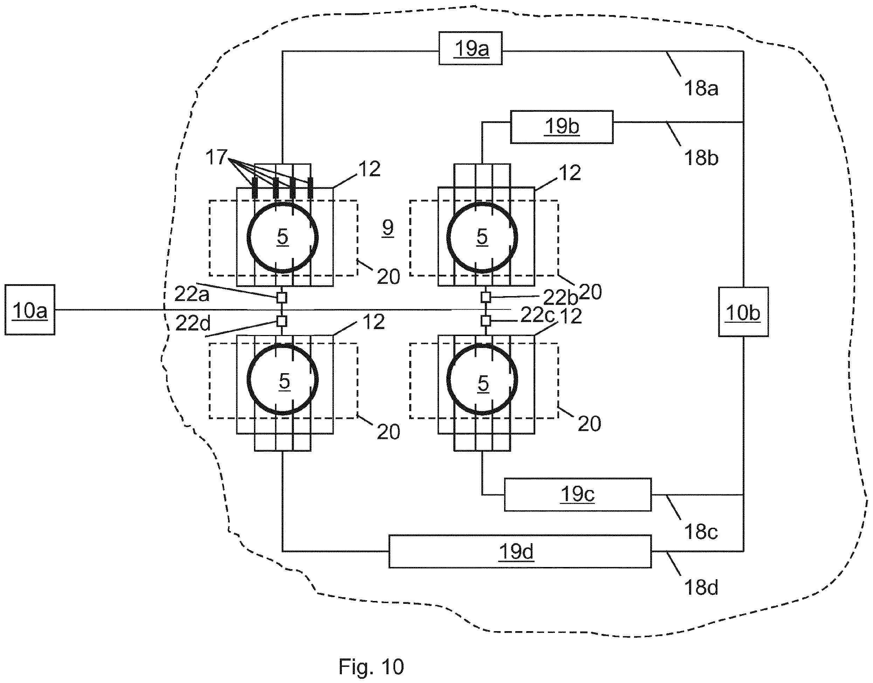

Die Figuren 9 und 10 zeigen die Ausführungsbeispiele der Figuren 6 und 7, wobei ebenfalls die weiteren Pfadwiderstände 22 a, b, c, d eingebracht sind.

Das Ausführungsbeispiel in der Figur 10 ist besonders geeignet, den Fügezustand zu überprüfen.

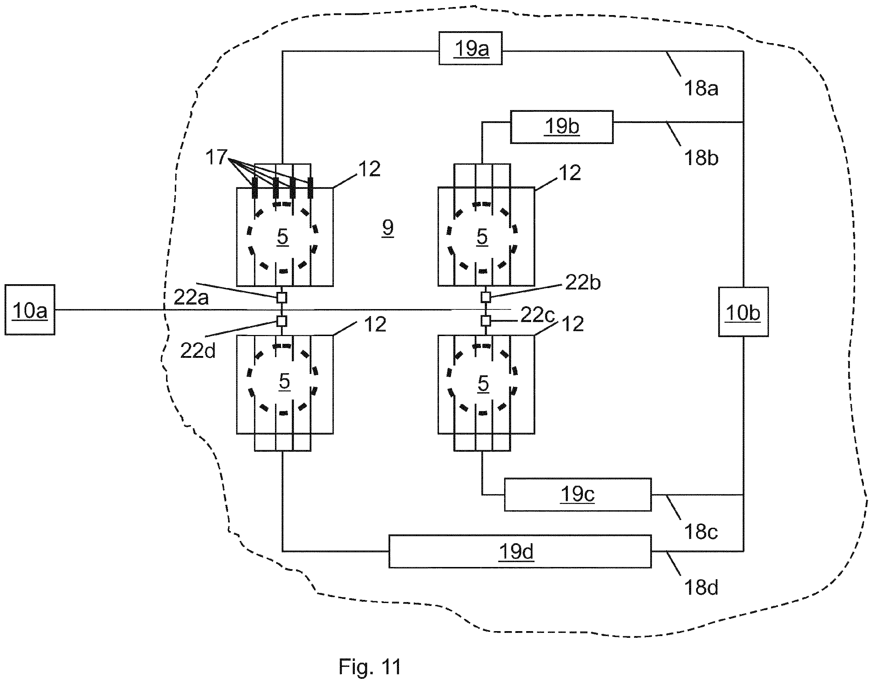

Die Figur 11 zeigt eine alternative Ausgestaltung, wobei die Deckschicht 9 die Messbereiche 12 vollständig bedeckt und dadurch elektrisch isoliert, so dass eine elektrische Verbindung der Messbereiche 12, insbesondere der Elektrodenstrukturen 13,14, erst nach dem stoffschlüssigen Fügen erfolgen kann, indem die Isolierung der Deckschicht 9 durch den Fügevorgang aufgehoben wird und ein elektrischer Kontakt zwischen den Elektrodenstrukturen und dem Fügebereich 5 in dem gefügten Zustand hergestellt ist, um den Kontaktierungszustand zu prüfen. In dem Ausführungsbeispiel in der Figur 11 sind ebenfalls die weiteren Pfadwiderstände 22 a, b, c, d eingebracht. Diese Ausführungsform mit einer Deckschicht 9, die die Messbereiche 12 gegenüber dem anzupressenden Kontaktierungspartner elektrisch isoliert ist besonders geeignet, den Kontaktierungszustand zu prüfen.

Bei weiteren, nicht gezeigten Ausführungsbeispielen kann der Sensorabschnitt 6 Messbereiche 12 mit vollständiger Isolierung wie in der Figur 11 gezeigt, und Messbereiche 12 mit kontaktfreien Bereichen wie in der Figur 7 gezeigt oder ohne Deckschicht 9 aufweisen, so dass über einen gemeinsamen Sensorabschnitt 6 sowohl der Fügezustand als auch der Kontaktierungszustand überprüft werden kann.

Es ist auch möglich, dass an einem Fügebereich 5 sowohl ein Messbereich 12, welcher kontaktierend zur Prüfung des Fügezustands ausgebildet ist, und ein zweiter, dazu zum Beispiel 90° verdrehter Messbereich 12 angeordnet ist, welcher zur Prüfung des Kontaktierungszustands elektrisch isoliert ist. In diesem Zusammenhang kann vorgesehen sein, dass der Sensorabschnitt 6 mehrere Kontaktbereiche 10 a, b aufweist, wobei ein Paar der Kontaktbereiche 10 a, b den isolierten Messbereichen 12 und ein weiteres Paar der Kontaktbereiche den kontaktfähigen Messbereichen 12 zugeordnet ist.

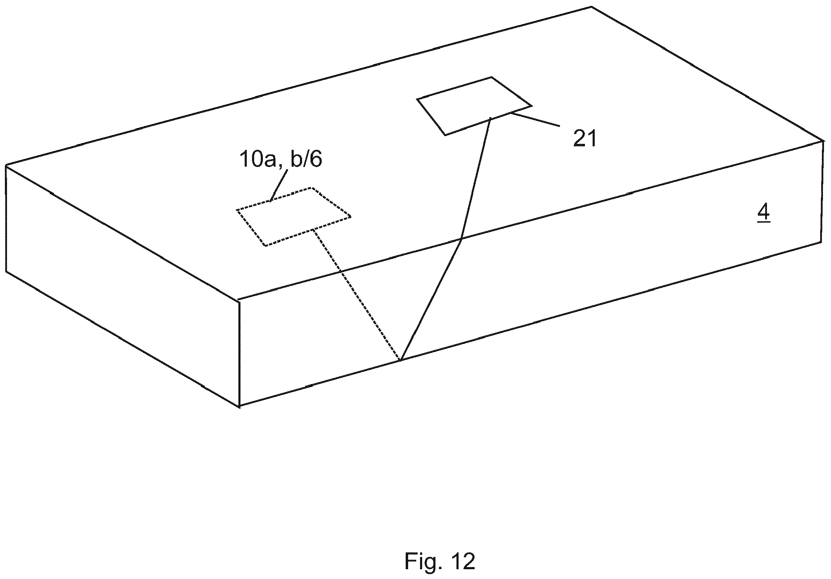

Bei weiteren Ausführungsformen können Messbereich 12 sowohl parallel als auch in Reihe geschaltet werden. Die Figur 12 zeigt das Kontaktelement 4 in einer schematischen, dreidimensionalen Darstellung, wobei auf einer Unterseite der Kontaktbereich 10 a, b oder der Sensorabschnitt 6 angeordnet ist. Über die Bedruckung kann ein Anschluss an den Kontaktbereich 10 a, b oder an den Sensorabschnitt 6 auf den Kontaktierungspartner aufgedruckt werden und auf diese Weise einfacher zugänglich gemacht werden. Beispielsweise befindet sich ein Abgriffsbereich 21 auf einer gegenüberliegenden Seite des Kontaktelements 4. Durch einen derartigen Abgriffsbereich 21 kann beispielsweise beim Fügeprozess ein Niederhalter genutzt werden, um den Sensorabschnitt 6 mit der Auswerteeinrichtung 11 signaltechnisch zu verbinden, so dass die Überprüfung des Fertigungszustands in einfacher Weise in die Fertigung integriert werden kann.

Der Sensorabschnitt 6 ermöglicht somit eine Überwachung einer elektrischen Verbindungsstelle in einem Fügebereich 5 bezüglich physikalischer Parameter wie z.B. Kontaktierung, Vorhandensein einer Schweißnaht, Positionierung, Temperatur etc. Damit können kosten- und bauraumeffizient messende oder detektierende Funktionen für einzelnen Kontakte oder Batteriezellen in dem Sensorabschnitt 6 als ein Produkt integriert werden. Nicht sichtbare bzw. nicht zugängliche Spalte, die beim Schweißen geschlossen werden müssen, um den Schweißprozess definiert gestalten zu können, können sensorisch / detektierend überwacht werden und es können Signale nach außen bereitgestellt werden. Indirekte Prozessüberwachungsprozesse können durch einen direkten Überwachungsprozess ersetzt bzw. ergänzt werden.

Es werden im Bereich der Schweißstelle oberflächliche Strukturen aufgebracht, die ermöglichen, dass der Kontaktzustand für die Schweißung definiert ist. Die oberflächlichen Strukturen ermöglichen, dass der "Kontaktzustand" der Fügepartner messtechnisch ausgewertet werden kann (Elektrischer Kontakt, Druck -> Widerstandsänderung usw.). Die Ausführung der Leiterbahnen/Kontaktflächen ist derart gestaltet, dass eine digitale (ja/nein) oder differenziertere Information über den Kontakt- oder Verbindungszustand möglich ist (Widerstandskodiert, Temperaturerfassend). Die elektrische Kontaktierung der Signale über eine Vorrichtung oder z.B. über das Niederhalte-Werkzeug, welches den Ableiter auf die Batteriezelle drückt, hergestellt wird.

Leiterbahnen im Bereich der Anbindungsstelle, die in den Kontakt/Interaktion mit dem anzuschweißenden Bauteil kommen, und so den Zustand der "Nullspalt"-Bildung detektieren können, bzw. Prozessinformationen wie eine Schweißtemperatur rückmelden können, welche direkt auf der Batterie oder dem anzuschweißenden Bauteil erfasst werden kann. Ausführung in einer Art und Weise, die es ermöglicht über den Kontaktzustand eine messtechnische Aussage zu treffen z.B. über Wiederstände kodiert die Anzahl oder Ausdehnung der Anbindungspunkte zu detektieren.

Oberflächlich aufgebrachte Leiterbahnen auf dem Ableiter integriert werden, die separate Leiterbahnen in Form von Kabel, Flachbandkabel ersetzen. Aufgedruckte Schichten werden im Rahmen des Anpressens kontaktiert (z.B. elastische, elektrisch leitende Schichten) oder über den Fügeprozess aktiviert (Abwärme der Schweißnaht) oder über eine dedizierte Einwirkung des Lasers aktiviert (ausreichende Anwärmung für die Aktivierung).

### Mögliche Vorteile sind:

Deterministische Detektion des Kontakts zwischen Batterie und Ableiter wird möglich; sensorische Funktionen, die über den Schweißprozess hinaus Bestand haben, können später weiterverwendet werden den Betriebszustand des Produkts in seinem Betrieb zu erfassen; Sensorik-Leitungen können im weiten Bereich eingespart werden, wenn diese direkt auf der Bauteiloberfläche aufgebracht werden; Anbindungen können ohne Schweißen realisiert werden, da die gedruckten schichten ausreichend dünn sind, um im "Spalt" nicht funktionswirksam zu sein. Vorgesinterte leitfähige Schichten sind ausreichend robust, um diese im Spalt zu klemmen.

### Bezugszeichenliste

- 1: Batterieanordnung
- 2: Batterie
- 3a, b: Pole
- 4: Kontaktelement
- 5: Fügebereich
- 6: Sensorabschnitt
- 7: Bodenschicht
- 8: Prüfstruktur
- 9: Deckschicht
- 10a, b: Kontaktbereiche
- 11: Auswerteeinrichtung
- 12: Messbereich
- 13: erste Elektrodenstruktur
- 14: zweite Elektrodenstruktur
- 15: Einzelelektrodenabschnitte
- 16: Einzelkontaktpaare
- 17: Einzelwiderstand
- 18 a, b, c, d: Messspfad
- 19 a, b, c, d: Pfadwiderstand
- 20: Freibereiche
- 21: Abgriffsbereich

## Patentansprüche

1. Batterieanordnung (1)
mit mindestens einer Batterie (2), wobei die Batterie (2) mindestens einen Pol (3a) zur elektrischen Kontaktierung der Batterie (2) aufweist, wobei der Pol (3a) einen ersten Kontaktierungspartner bildet,
mit einem Kontaktelement (4) zur elektrischen Kontaktierung des Pols (3a), wobei das Kontaktelement (4) einen zweiten Kontaktierungspartner bildet,
wobei in einem Fügezustand als einen ersten Fertigungszustand der Batterieanordnung (1) das Kontaktelement (4) in mindestens einem Fügebereich (5) fügebereit und/oder fügegerecht auf dem Pol (3a) aufliegt und/oder wobei in einem Kontaktierungszustand der Batterieanordnung (1) als einen zweiten Fertigungszustand das Kontaktelement (4) mit dem Pol (3a) in einem und/oder dem mindestens einem Fügebereich (5) stoffschlüssig verbunden ist,
mit einem Sensorabschnitt (6) zur Überprüfung von mindestens einem der Fertigungszustände der Batterieanordnung (1),
**dadurch gekennzeichnet,**
**dass** der Sensorabschnitt (6) zwischen dem Kontaktelement (4) und der Batterie (2) angeordnet ist.

2. Batterieanordnung (1) nach Anspruch 1, **dadurch gekennzeichnet, dass** der Sensorabschnitt umlaufend und/oder überdeckend zu dem mindestens einen Fügebereich (5) angeordnet ist.

3. Batterieanordnung (1) nach Anspruch 1 oder 2, **dadurch gekennzeichnet, dass** der Sensorabschnitt (6) auf einem der Kontaktierungspartner zumindest abschnittsweise oder vollständig durch Beschichten, insbesondere Bedrucken aufgebracht ist.

4. Batterieanordnung (1) nach einem der vorhergehenden Ansprüche, **dadurch gekennzeichnet, dass** der Sensorabschnitt (6) eine durch Beschichten aufgebrachte Prüfstruktur (8) umfasst, wobei die Prüfstruktur (8) zumindest abschnittsweise leitfähig ausgebildet ist.

5. Batterieanordnung (1) nach einem der vorhergehenden Ansprüche, **dadurch gekennzeichnet, dass** der Sensorabschnitt (6) eine Dicke von weniger als 25µm, insbesondere von weniger als 10µm und im Speziellen von weniger als 1 µm aufweist.

6. Batterieanordnung (1) nach einem der vorhergehenden Ansprüche, dass der Sensorabschnitt (6) mindestens einen Messbereich (12) aufweist, wobei der Messbereich (12) umlaufend und/oder deckungsgleich und/oder überlappend zu dem Fügebereich (5) angeordnet ist, wobei in dem Messbereich (12) der Fertigungszustand der Batterieanordnung (1) in dem Fügebereich prüfbar ist.

7. Batterieanordnung (1) nach Anspruch 6, **dadurch gekennzeichnet, dass** der Messbereich (12) eine erste Elektrodenstruktur (13) und eine zweite Elektrodenstruktur (14) aufweist, wobei die erste Elektrodenstruktur (13) und die zweite Elektrodenstruktur (14) elektrisch voneinander getrennt sind, wobei der Fügebereich (5) zwischen den Elektrodenstrukturen (13, 14) angeordnet sind.

8. Batterieanordnung (1) nach Anspruch 6 oder 7, **dadurch gekennzeichnet, dass** der Messbereich (12) für eine elektrische Durchgangsmessung zur Prüfung des Fertigungszustands der Batterieanordnung (1) in dem Fügebereich (5) ausgebildet ist, wobei die Elektrodenstrukturen (13,14) in Abhängigkeit des Fertigungszustands durch den aufgelegten Kontaktierungspartner und/oder den Fügebereich (5) miteinander leitfähig verbunden werden.

9. Batterieanordnung (1) nach einem der vorhergehenden Ansprüche, **dadurch gekennzeichnet, dass** der Messbereich (12) für eine elektrische Widerstandsmessung zur Prüfung des Fertigungszustands der Batterieanordnung (1) in dem Fügebereich (5) ausgebildet ist, wobei die Elektrodenstrukturen (13,14) mehrere Einzelkontaktpaare (16) bilden, wobei die Einzelkontaktpaare (16) jeweils mindestens einen Einzelwiderstand (17) aufweisen, wobei die Einzelkontaktpaare (16) in Abhängigkeit des Fertigungszustands leitfähig miteinander verbunden werden, so dass ein Gesamtmessbereichswiderstand gebildet ist, wobei auf Basis des Gesamtmessbereichswiderstands eine Anbindungslänge abschätzbar ist.

10. Batterieanordnung (1) nach Anspruch 9, **dadurch gekennzeichnet, dass** die Einzelkontaktpaare (16) über den jeweiligen Einzelwiderstand (17) kodiert sind, so dass auf Basis des Gesamtmessbereichswiderstands eine Anbindungsverteilung abschätzbar ist.

11. Batterieanordnung (1) nach einem der Ansprüche 5 bis 10, **dadurch gekennzeichnet, dass** der Sensorabschnitt (6) mindestens zwei der Messbereiche (12) aufweist, wobei die Messbereiche (12) in dem Sensorabschnitt (6) derart verschaltet sind, dass ein Gesamtabschnittswiderstand gebildet ist, wobei auf Basis des Gesamtabschnittswiderstands der Fertigungszustand der Batterieanordnung (1) in dem jeweiligen Fügebereich (5) mit den unterschiedlichen Messbereichen (12) abschätzbar ist.

12. Batterieanordnung (1) nach Anspruch 11, **dadurch gekennzeichnet, dass** die Messbereiche (12) in einem Widerstandsnetzwerk angeordnet sind und/oder ein Widerstandsnetzwerk bilden, wobei in dem Widerstandsnetzwerk unterschiedliche Messpfade (18, 18a, b, c, d) und/oder Messpfadabschnitte durch Pfadwiderstände (19, 19 a, b, c, d, 22 a, b, c, d) kodiert sind und/oder die Messbereiche (12) die Einzelwiderstände (17) aufweisen, so dass der Gesamtabschnittswiderstand gebildet ist.

13. Batterieanordnung (1) nach Anspruch 12, **dadurch gekennzeichnet, dass** jeder Messpfad (18, 18, b, c, d) und/oder Messpfadabschnitt vor dem Messbereich (12) und hinter dem Messbereich (12) einen Pfadwiderstand (19, 19 a, b, c, d, 22 a, b, c, d) aufweist, wobei die Pfadwiderstände (19, 19 a, b, c, d, 22 a, b, c, d) der Messpfade (18, 18, b, c, d), unterschiedlich ausgebildet, so dass der jeweilige Messpfad (18, 18, b, c, d) über die Kombination der Pfadwiderstände eindeutig kodiert ist und/oder so dass über den Gesamtwiderstand auf den Fügezustand der Fügebereiche (12) geschlossen werden kann.

14. Batterieanordnung (1) nach einem der vorhergehenden Ansprüche, **dadurch gekennzeichnet, dass** der Sensorabschnitt (6) zur Überprüfung des Fügezustands ausgebildet ist, wobei der Sensorabschnitt (6) zumindest abschnittsweise kontaktfähig ist, so dass der Sensorabschnitt (6) in dem Fügezustand mit dem aufgelegten Kontaktierungspartner elektrisch kontaktieren kann, um den Fügezustand zu prüfen und/oder dass der Sensorabschnitt (6) zur Überprüfung des Kontaktierungszustands ausgebildet ist, wobei der Sensorabschnitt (6) in dem Kontaktierungszustand zumindest abschnittsweise elektrisch isoliert ist, so dass der Sensorabschnitt (6) in dem Fügezustand von dem aufgelegten Kontaktierungspartner elektrisch isoliert ist und in dem Kontaktierungszustand elektrisch verbunden ist, um den Kontaktierungszustand zu prüfen.

15. Batteriepack, **gekennzeichnet durch** eine Vielzahl der Batterieanordnungen (1) nach einem der vorhergehenden Ansprüche.

16. Verfahren zum Prüfen des Fertigungszustands einer Batterieanordnung (1) nach einem der Ansprüche 1 bis 14, wobei die Batterieanordnung (1) in einen der Fertigungszustände gebracht wird und der Fertigungszustand der Batterieanordnung (1) über den Sensorabschnitt (6) geprüft wird.
